# EUROPÄISCHE PATENTSCHRIFT

(11) **EP 2 400 575 B1**
(45) Veröffentlichungstag und Bekanntmachung des Hinweises auf die Patenterteilung: **23.03.2016**
(21) Anmeldenummer: 10167213.7
(22) Anmeldetag: 24.06.2010
(51) Int. Cl.: H01L 51/46

(54) **Optoelektronisches Bauelement mit organischen Schichten**
Optoelectronic construction element with organic layers
Composant optoélectronique doté de couches organiques

(43) Veröffentlichungstag der Anmeldung: 28.12.2011
(73) Patentinhaber: heliatek GmbH, 01139 Dresden (DE)
(72) Erfinder: Hildebrandt , Dr. Dirk, 89233 Neu-Ulm (DE); Mattersteig , Dr. Gunter, 89075 Ulm (DE); Pfeiffer, Dr. Martin, 01309 Dresden (DE); Tsaryova, Dr. Olga in Gerdes, 89081 Ulm (DE); Uhrich, Dr. Christian, 01307 Dresden (DE); Vetter, Dr. Serge, 89075 Ulm (DE); Weiss, Dr. Andre, 89081 Ulm (DE)

(56) Entgegenhaltungen:
- EP-A1- 1 449 902
- WO-A1-2006/092134
- WO-A2-2009/051390
- CHANG Y J ET AL: "Triaryl linked donor acceptor dyads for high-performance dye-sensitized solar cells", TETRAHEDRON, ELSEVIER SCIENCE PUBLISHERS, AMSTERDAM, NL, vol. 65, no. 46, 14 November 2009 (2009-11-14), pages 9626-9632, XP026682478, ISSN: 0040-4020, DOI: 10.1016/J.TET.2009.09.036 [retrieved on 2009-09-19]
- Wenjun Wu ET AL: "Efficient and stable dye-sensitized solar cells based on phenothiazine sensitizers with thiophene units", Journal of Materials Chemistry, vol. 20, no. 9, 1 January 2010 (2010-01-01), page 1772, XP055212557, ISSN: 0959-9428, DOI: 10.1039/b918282a

## Beschreibung

Die Erfindung betrifft ein optoelektronisches Bauelement bestehend aus einer Einfach-, Tandem- oder Mehrfachzelle mit einer Elektrode und einer Gegenelektrode und mindestens einer organischen Schicht beinhaltend eine Verbindung der allgemeinen Formel EWG-D-EWG mit mindestens einem Substituenten zwischen der Elektrode und der Gegenelektrode.

Die Forschung und Entwicklung an organischen Solarzellen hat insbesondere in den letzten zehn Jahren stark zugenommen. Der maximale bisher für so genannte "kleine Moleküle" berichtete Wirkungsgrad liegt bei 5.7% [Jiangeng Xue, Soichi Uchida, Barry P. Rand, and Stephen R. Forrest, Appl. Phys. Lett. 85 (2004) 5757]. Unter kleinen Molekülen werden im Sinne der vorliegenden Erfindung nicht-polymere organische, monodisperse Moleküle im Massebereich zwischen 100 und 2000 Gramm/Mol verstanden. Damit konnten bisher die für anorganische Solarzellen typischen Effizienzen von 10-20% noch nicht erreicht werden. Organische Solarzellen unterliegen aber denselben physikalischen Limitierungen wie anorganische Solarzellen, weshalb nach entsprechender Entwicklungsarbeit zumindest theoretisch ähnliche Effizienzen zu erwarten sind.

Organische Solarzellen bestehen aus einer Folge dünner Schichten (die typischerweise jeweils 1nm bis 1µm dick sind) aus organischen Materialien, welche bevorzugt im Vakuum aufgedampft oder aus einer Lösung aufgeschleudert werden. Die elektrische Kontaktierung kann durch Metallschichten, transparente leitfähige Oxide (TCOs) und/oder transparente leitfähige Polymere (PEDOT-PSS, PANI) erfolgen.

Eine Solarzelle wandelt Lichtenergie in elektrische Energie um. In diesem Sinne wird der Begriff "photoaktiv" als Umwandlung von Lichtenergie in elektrische Energie verstanden. Im Gegensatz zu anorganischen Solarzellen werden bei organischen Solarzellen durch das Licht nicht direkt freie Ladungsträger erzeugt, sondern es bilden sich zunächst Exzitonen, also elektrisch neutrale Anregungszustände (gebundene Elektron-Loch-Paare). Erst in einem zweiten Schritt werden diese Exzitonen in freie Ladungsträger getrennt, die dann zum elektrischen Stromfluß beitragen.

Der Vorteil solcher Bauelemente auf organischer Basis gegenüber den konventionellen Bauelementen auf anorganischer Basis (Halbleiter wie Silizium, Galliumarsenid) sind die teilweise extrem hohen optischen Absorptionskoeffizienten (bis zu 2x10⁵ cm⁻¹), die es erlauben, effiziente Absorberschichten von nur wenigen Nanometern Dicke herzustellen, so dass sich die Möglichkeit bietet, mit geringem Material- und Energieaufwand sehr dünne Solarzellen herzustellen. Weitere technologische Aspekte sind die niedrigen Kosten, wobei die verwendeten organischen Halbleitermaterialien bei Herstellung in größeren Mengen sehr kostengünstig sind; die Möglichkeit, flexible großflächige Bauteile auf Plastikfolien herzustellen, und die nahezu unbegrenzten Variationsmöglichkeiten und die unbegrenzte Verfügbarkeit der organischen Chemie.

Da im Herstellungsprozess keine hohen Temperaturen benötigt werden, ist es möglich, organische Solarzellen als Bauteile sowohl flexibel als auch großflächig auf preiswerten Substraten, z.B. Metallfolie, Plastikfolie oder Kunststoffgewebe, herzustellen. Dies eröffnet neue Anwendungsgebiete, welche den konventionellen Solarzellen verschlossen bleiben. Auf Grund der nahezu unbegrenzten Anzahl verschiedener organischer Verbindungen können die Materialien für ihre jeweilige Aufgabe maßgeschneidert werden.

Eine in der Literatur bereits vorgeschlagene Realisierungsmöglichkeit einer organischen Solarzelle besteht in einer pin -Diode [Martin Pfeiffer, "Controlled doping of organic vacuum deposited dye layers: basics and applications", PhD thesis TU-Dresden, 1999.] mit folgendem Schichtaufbau:
0. Träger, Substrat,
1. Grundkontakt, meist transparent,
2. p- Schicht(en),
3. i- Schicht(en)
4. n- Schicht(en),
5. Deckkontakt.

Hierbei bedeutet n bzw. p eine n- bzw. p-Dotierung, die zu einer Erhöhung der Dichte freier Elektronen bzw. Löcher im thermischen Gleichgewichtszustand führt. In diesem Sinne sind derartige Schichten primär als Transportschichten zu verstehen. Die Bezeichnung i-Schicht bezeichnet demgegenüber eine undotierte Schicht (intrinsische Schicht). Eine oder mehrere i-Schicht(en) können hierbei Schichten sowohl aus einem Material, als auch eine Mischung aus zwei Materialien (sogenannte interpenetrierende Netzwerke) bestehen. Im Gegensatz zu anorganischen Solarzellen liegen die Ladungsträgerpaare in organischen Halbleitern nach Absorption jedoch nicht frei vor, sondern sie bilden wegen der weniger starken Abschwächung der gegenseitigen Anziehung ein Quasiteilchen, ein so genanntes Exziton. Um die im Exziton vorhandene Energie als elektrische Energie nutzbar zu machen, muss dieses Exziton in freie Ladungsträger getrennt werden. Da in organischen Solarzellen nicht ausreichend hohe Felder zur Trennung der Exzitonen zur Verfügung stehen, wird die Exzitonentrennung an photoaktiven Grenzflächen vollzogen. Die photoaktive Grenzfläche kann als eine organische Donator-Akzeptor-Grenzfläche [C.W. Tang, Appl. Phys. Lett. 48 (1986) 183] oder eine Grenzfläche zu einem anorganischen Halbleiter [B. O'Regan, M. Grätzel, Nature 1991, 353, 737])] ausgeprägt sein. Die Exzitonen gelangen durch Diffusion an eine derartige aktive Grenzfläche, wo Elektronen und Löcher voneinander getrennt werden. Diese kann zwischen der p- (n-) Schicht und der i-Schicht bzw. zwischen zwei i-Schichten liegen. Im eingebauten elektrischen Feld der Solarzelle werden die Elektronen nun zum n-Gebiet und die Löcher zum p-Gebiet abtransportiert. Vorzugsweise handelt es sich bei den Transportschichten um transparente oder weitgehend transparente Materialien mit großer Bandlücke (wide-gap). Als wide-gap Materialien werden hierbei Materialien bezeichnet, deren Absorptionsmaximum im Wellenlängenbereich <450nm liegt, bevorzugt bei <400nm.

Da durch das Licht immer erst Exzitonen erzeugt werden und noch keine freien Ladungsträger, spielt die rekombinationsarme Diffusion von Exzitonen an die aktive Grenzfläche eine kritische Rolle bei organischen Solarzellen. Um einen Beitrag zum Photostrom zu leisten, muss daher in einer guten organischen Solarzelle die Exzitonendiffusionslänge die typische Eindringtiefe des Lichts deutlich übersteigen, damit der überwiegende Teil des Lichts genutzt werden kann. Strukturell und bezüglich der chemischen Reinheit perfekte organische Kristalle oder Dünnschichten erfüllen durchaus dieses Kriterium. Für großflächige Anwendungen ist allerdings die Verwendung von monokristallinen organischen Materialien nicht möglich und die Herstellung von Mehrfachschichten mit ausreichender struktureller Perfektion ist bis jetzt noch sehr schwierig.

Falls es sich bei der i-Schicht um eine Mischschicht handelt, so übernimmt die Aufgabe der Lichtabsorption entweder nur eine der Komponenten oder auch beide. Der Vorteil von Mischschichten ist, dass die erzeugten Exzitonen nur einen sehr kurzen Weg zurücklegen müssen bis sie an eine Domänengrenze gelangen, wo sie getrennt werden. Der Abtransport der Elektronen bzw. Löcher erfolgt getrennt in den jeweiligen Materialien. Da in der Mischschicht die Materialien überall miteinander im Kontakt sind, ist bei diesem Konzept entscheidend, dass die getrennten Ladungen eine lange Lebensdauer auf dem jeweiligen Material besitzen und von jedem Ort aus geschlossene Perkolationspfade für beide Ladungsträgersorten zum jeweiligen Kontakt hin vorhanden sind. Diese geschlossenen Perkolationspfade werden üblicherweise durch eine gewisse Phasenseparation in der Mischschicht realisiert, d.h. die beiden Komponenten sind nicht völlig durchmischt, sondern es befinden sich (bevorzugt kristalline) Nanopartikel aus jeweils einem Material in der Mischschicht. Diese teilweise Entmischung wird als Phasenseparation bezeichnet.

Die so generierten freien Ladungsträger können nun zu den Kontakten transportiert werden. Durch Verbinden der Kontakte über einen Verbraucher kann die elektrische Energie genutzt werden. Von besonderer Bedeutung ist dabei, dass Exzitonen, die im Volumen des organischen Materials generiert wurden, an diese photoaktive Grenzfläche diffundieren können.

Die rekombinationsarme Diffusion von Exzitonen an die aktive Grenzfläche spielt daher eine kritische Rolle bei organischen Solarzellen. Um einen Beitrag zum Photostrom zu leisten, muss deshalb in einer guten organischen Solarzelle die Exzitonendiffusionslänge zumindest in der Größenordnung der typischen Eindringtiefe des Lichts liegen, damit der überwiegende Teil des Lichts genutzt werden kann. Die bereits erwähnten möglichen hohen Absorptionskoeffizienten sind dabei besonders vorteilhaft für die Herstellung besonders dünner organischer Solarzellen.

Dennoch ist es auch bedeutsam, strukturell und bezüglich ihrer chemischen Reinheit möglichst perfekte organische Kristalle oder wohlgeordnete Dünnschichten zu erzeugen, da diese die höchsten Beweglichkeiten sowohl für Exzitonen als auch für Ladungsträger besitzen. Größere organische Kristalle sind jedoch für großflächige Anwendungen ungeeignet, da sie zum einen schwer herstellbar sind und zum anderen mechanisch instabil sind. Die Herstellung organischer Dünnschichten mit definierter Nahordnung der Moleküle ist daher eine vordringliche Aufgabe bei der Entwicklung organischer Solarzellen.

Dabei dient diese Nahordnung der Moleküle sowohl dem verlustarmen Transport von Exzitonen als auch nach deren Trennung in freie Ladungsträger dem Transport von Elektronen beziehungsweise Löchern. Eine hohe Beweglichkeit für Ladungsträger in diesen organischen Absorberschichten ist daher eine weitere Voraussetzung für deren Nutzbarkeit. Besonders vorteilhaft ist dabei der Fall, bei dem in einer organischen Mischschicht aus zwei verschiedenen organischen Komponenten eine der Komponenten bevorzugt Elektronen leitend und die andere Komponente bevorzugt Löcher leitend ist.

Statt die Exzitonendiffusionslänge zu vergrößern, kann man auch den mittleren Abstand bis zur nächsten Grenzfläche verkleinern. Dies kann durch Verwendung sehr dünner Absorberschichten (mit typischen Schichtdicken um 10nm) geschehen. Dabei wird jedoch nur eine teilweise Extinktion des einfallenden Lichtes erreicht, was ein wesentlicher Grund für die bisher unzureichende Effizienz organischer Solarzellen ist.

Aus der WO 00/33396 ist die Bildung eines so genannten interpenetrierenden Netzwerkes zweier organischer Materialien in der Absorberschicht bekannt: Eine Schicht enthält eine kolloidal gelöste Substanz, die so verteilt ist, dass sich im Volumenmaterial zwei Netzwerke bilden, die jeweils geschlossene Leitungspfade für Ladungsträger besitzen, so dass jede Ladungsträgerart (Löcher und Elektronen) auf geschlossenen Leitungspfaden je eines Materials sehr verlustarm zu den äußeren Kontakten abfließen kann (Perkolationsmechanismus). Die Aufgabe der Lichtabsorption übernimmt in einem solchen Netzwerk entweder nur eine der Komponenten oder auch beide. Der Vorteil dieser Mischschicht ist, dass die erzeugten Exzitonen nur einen sehr kurzen Weg zurücklegen müssen, bis sie an eine Domänengrenze gelangen, wo sie getrennt werden. Der Abtransport der Elektronen bzw. Löcher erfolgt getrennt. Da in der Mischschicht die Materialien überall miteinander im Kontakt sind, ist bei diesem Konzept entscheidend, dass die getrennten Ladungen eine lange Lebensdauer auf dem jeweiligen Material besitzen und von jedem Ort aus geschlossene Perkolationspfade für beide Ladungsträgersorten zum jeweiligen Kontakt hin vorhanden sind. Mit diesem Ansatz konnten in polymeren Solarzellen Wirkungsgrade von 2,5% erreicht werden [C. J. Brabec et al., Advanced Functional Materials 11 (2001) 15].

Weitere bekannte Ansätze zur Realisierung bzw. Verbesserung der Eigenschaften von organischen Solarzellen sind im Folgenden aufgezählt:
Ein Kontaktmetall hat eine große und das andere eine kleine Austrittsarbeit, so dass mit der organischen Schicht eine Schottky-Barriere ausgebildet wird [US 4127738].

Die aktive Schicht besteht aus einem organischen Halbleiter in einem Gel oder Bindemittel [US 03844843, US 03900945, US 04175981 und US 04175982].

Herstellung einer Transportschicht, die kleine Partikel (Größe 0.01 - 50µm) enthält, welche den Ladungsträgertransport übernehmen [US 5965063].

Eine Schicht enthält zwei oder mehr Arten von organischen Pigmenten, die verschiedene spektrale Charakteristika besitzen [JP 04024970].

Eine Schicht enthält ein Pigment, das die Ladungsträger erzeugt, und zusätzlich ein Material, das die Ladungsträger abtransportiert [JP 07142751].

Polymerbasierte Solarzellen, die Kohlenstoffteilchen als Elektronenakzeptoren enthalten [US05986206].

Dotierung von o.g. Mischsystemen zur Verbesserung der Transporteigenschaften in Mehrschichtsolarzellen [DE 102 09 789 A1].

Anordnung einzelner Solarzellen übereinander (Tandemzelle) [US 04461922, US 06198091 und US 06198092].

Tandemzellen können durch Verwendung von p-i-n Strukturen mit dotierten Transportschichten großer Bandlücke weiter verbessert werden [DE 10 2004 014046 A1].

Trotz der oben beschriebenen Vorteile bei interpenetrierenden Netzwerken besteht ein kritischer Punkt darin, dass in der Mischschicht geschlossene Transportpfade für sowohl Elektronen als auch Löcher zu ihren jeweiligen Kontakten vorhanden sein müssen. Da außerdem die einzelnen Materialien jeweils nur einen Teil der Mischschicht ausfüllen, verschlechtern sich die Transporteigenschaften für die jeweiligen Ladungsträgerarten (Elektronen und Löcher) im Vergleich zu den reinen Schichten deutlich.

Für polymere Materialien wurden bereits Mischschichtsysteme gefunden, die den genannten interpenetrierenden Netzwerken nahe kommen. So berichten Ma, Heeger und Mitarbeiter (in: Advanced Functional Materials 15 (2005) 1617-1622) über polymere Solarzellen mit einer aktiven Schicht aus P3HT:PCBM, bei der die aktive Schicht durch eine thermische Behandlung so modifiziert wird, dass sich ein interpenetrierendes Netzwerk im Polymer ausbildet, welches zu Solarzellen mit 5% Wirkungsgrad führt. P3HT steht dabei für Poly(3-Hexyl-Thiophen), ein Polymer aus der Reihe der Poly(3-Alkyl-Thiophene) (P3AT). Der Nachweis der Netzwerkbildung erfolgte in dieser Arbeit durch Röntgenbeugung und Transmissionselektronenmikroskopie. Ebenfalls bei Verwendung der Polymermischung P3HT:PCBM konnte die Gruppe von Yang Yang zeigen (Nature Materials 4 (2005) 864), dass auch über die Wahl geeigneter Wachstumsraten eine Ausbildung bevorzugter Molekülordnungen erfolgen kann, welche Solarzelleneffizienzen bis zu 3,6% erlauben. Das dabei erfolgreich verwendete Polymer P3HT ist ein Poly-Thiophen mit einer am 3. Kohlenstoff-Atom angebrachten Hexylkette. Das heißt, es wird eine sechs C-Atome lange Seitenkette verwendet.

Die Bildung geordneter molekularer Strukturen ist daher von zentralem Interesse für organische Solarzellen. Die Fragestellung ist dabei der in organischen Feldeffekttransistoren (OFETs) ähnlich. Der Unterschied von Solarzellen zu OFETs ist jedoch folgender: OFETs sollen einen bevorzugten Ladungsträgertransport parallel zum Substrat haben. Solarzellen hingegen sollen ihre Ladungsträger senkrecht zum Substrat möglichst schnell und verlustarm an die in der Regel flächig ausgebildeten äußeren Elektroden abgeben, wobei in einer häufig genutzten Anordnung Ladungstransportschichten zwischen der oder den absorbierenden Schichten und den Elektroden eingebaut sind. Daraus lässt sich ableiten, dass auch die molekularen Strukturen in Solarzellen anders ausgeprägt sein sollen als in OFETs.

Zur Verbesserung der organischen intrinsischen sind verschiedene Ansätze bekannt:
In der WO002006092134A1 werden Verbindungen offenbart, die über einen Akzeptor-Donor-Akzeptor-Aufbau verfügen, wobei der Donorblock ein ausgedehntes n-System besitzt.

In der DE60205824T2 werden Thienothiophenderivate offenbart, die mit weiteren Aromaten ein n-System bilden und an beiden Seiten von Alkylgruppen eingerahmt sind, und deren Verwendung in organischen Halbleitern.

In der WO 2009/105042 werden Polythiophene offenbart, bei denen Thienothiophen in die Polymerkette mit eingebaut wurden. In der WO2009/105042 tragen Polythiophene Längere Alkylseitenketten mit 8 bis 20 C-Atomen.

In der WO2009051390 werden Thiophen basierte Akzeptor-Donator Farbstoffe für den Einsatz in farbstoffsensitiven Solarzellen offenbart.

In der US2009/0221740A1 werden kondensierte Thiophen-Pyrrol-Thiophen als Wiederholeinheit in Copolymeren für die Verwendung in organischen Solarzellen beschrieben.

Die Nachteile bei der Verwendung von Polymeren bestehen vor allem darin, dass zur Beschichtung mit Polymeren in Lösung gearbeitet werden muss und somit die Verwendung von Vakuumbeschichtungstechnik wie bei der Verwendung von kleinen Molekülen nicht möglich ist. Weiterhin ergeben sich Probleme hinsichtlich einer einheitlichen Molmassenverteilung bei Beschichtung aus Lösung. Ein weiteres Problem stellt die geringe Variationsmöglichkeit hinsichtlich der Abfolge der Monomeren dar. Im allgemeine werden hierbei 1 bis 2 Monomereneinheiten mittels verschiedener Polymerisationsverfahren zu einem Copolymer verbunden, wobei die Molmassenverteilung abhängig ist von der Polymerisationsart und den eingesetzten Anteilen der Monomereneinheiten. Durch die Beschränkung auf 2 Monomereneinheiten ergeben sich zudem kaum Variationsmöglichkeiten. Entsprechendes gilt auch für die in organischen Bauelementen eingesetzten Polymere.

In den letzten 3 Jahren konnten durch die verschiedenen Ansätze regelmäßig verbesserte Effizienzen für organische Solarzellen berichtet werden. Trotzdem sind die derzeitig erreichten Effizienzen nicht ausreichend für einen kommerziellen Einsatz.

Der Erfindung liegt die Aufgabe zu Grunde ein organisches optoelektronisches Bauelement anzugeben, das die Nachteile des Standes der Technik überwindet und zu einer verbesserten Effizienz führt.

Erfindungsgemäß wird die Aufgabe gelöst durch ein optoelektronisches Bauelement nach Anspruch 1.

Bevorzugt sind die heterocyclischen 5-Ringe unabhängig voneinander ausgesucht aus Thiophen, Selenophen, Furan oder Pyrrol.

Unter annellierten heterocyclischen 5-Ringen wird verstanden, dass ein heterocyclischer 5-Ring zwei benachbarte C-Atome mit einem weiteren heterocyclischen 5-Ring gemeinsam hat. Dabei können die annellierten 5-Ringe gleich oder verschiedenen sein.

Bevorzugt besitzt der mindestens eine Substituent n-Elektronen beispielsweise als freies Elektronenpaar oder in einer Mehrfachbindung, besonders bevorzugt ist der mindestens eine Substituent elektronenschiebend.

Bevorzugt ist der mindestens eine Substituent ausgesucht aus einer Gruppe bestehend aus Ethern, Thioethern, Aminen oder aus substituierten oder unsubstituierten Aromaten oder Heteroaromaten mit 4 bis 10 Atomen oder ein Alkenyl mit mindestens einer Doppelbindung in α-Position oder im Fall von 2 benachbarten Substituenten bilden diese einen heterocyclischen 5-, 6- oder 7-Ring aus, besonders bevorzugt ausgesucht aus Ethern oder Thioethern aus geradkettigen oder verzweigten C1 bis C8-Alkanen oder n-elektronenreichen Aromaten oder Heteroaromaten wie 5-Ring und 6-Ring-Heteroaromaten oder einem C1 bis C8 Alkenyl mit mindestens einer Doppelbindung in α-Position.

In einem Referenzbeispiel besteht der ausgedehnte Donorblock aus einer Abfolge von heterocyclischen 5-Ringen mit Vinylen, wobei der mindestens eine Substituent eine kovalente Bindung zum heterocyclischen 5-Ring und zum Vinylen besitzt und mit diesen selber einen 5-Ring bildet, wie in Formel Ia dargestellt: 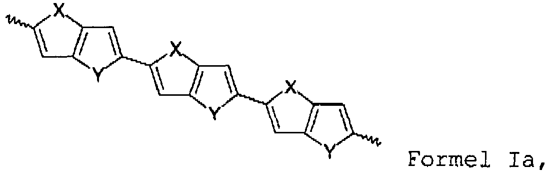 wobei X=S, Se, O, NR; Y=S, Se, O, NR mit R= Alkyl, Aryl sind.

In einem weiteren Referenzbeispiel sind mindestens 5 Doppelbindungen des ausgedehnten Donorblocks D über kovalente oder nicht-kovalente chemische Bindungen verbrückt, wobei sich die Verbrückung jeweils über eine 1,4-Position eines Diens bildet und mindestens 1 Atom umfasst. Bevorzugt sind mindestens 2 Verbrückungen kovalent ausgebildet. Besonders bevorzugt ist über mindestens eine kovalente Verbrückung ein 5-Ring ausgebildet, wie beispielsweise in Formel Ib und Ic dargestellt: 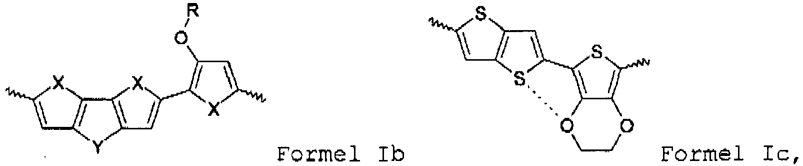 wobei X=S, Se, 0, N; Y=S, Se, O, NR, CR₂, SiR₂ C=CR₂, mit R= Alkyl, Aryl, R=Alkyl, Aryl sind.

Unter einer kovalente Verbrückung wird hierbei verstanden, dass ein Dien, welches als Abfolge von Doppelbindung-Einfachbindung-Doppelbindung definiert ist, in 1,4 Position über mindestens 2 kovalent Bindungen und mindestens 1 Atom einen Ring bilden.

Eine nicht-kovalente Verbrückung liegt vor, wenn 2 Atome innerhalb des ausgedehnten Donorblocks gegenseitige Anziehungskräfte besitzen, so dass über ein Dien in 1,4-Postion über mindestens eine nicht-kovalente Bindung und mindestens 1 Atom ein Ring gebildet wird. Anziehungskräfte liegen vor, wenn für das Atompaar aus veröffentlichten Kristallstrukturen bekannt ist, dass die Abstände kleiner als van-der-Waals-Radien sind ohne dass eine kovalente Bindung vorliegt oder sich für das Atompaar einen deutlichen Unterschied in der Elektronegativität ergibt.

Bevorzugt ist eine kovalente Brücke über ein S, Se, O, NR, CR₂, SiR₂, C=CR₂ mit exocyclischer Doppelbindung, B-R, P-R und P(O)R ausgebildet, worin R H, ein geradkettiges oder verzweigtes Alkan oder ein substituiertes oder unsubstituiertes Aren ist, wobei über die Verbrückung ein 5-Ring gebildet wird oder eine kovalente Brücke ist über ein - RN-NR- oder -N=N- oder -R₂C-CR₂- oder -RC=CR- ausgebildet, worin R unabhängig voneinander H, ein geradkettiges oder verzweigtes Alkan oder ein Aren sein kann, wobei die Verbrückung einen 6-Ring bildet.

Erfindungsgemäß ist eine nicht-kovalente Brücke über gegenseitige Anziehungen zwischen räumlich nahe liegenden Atomgruppe unterschiedlicher Elektronegativität wie beispielsweise S-O, S-F, S-N, Se-O, Se-N, Se-F, N-O, O-P.

Bevorzugt besitzt der ausgedehnte Donorblock mindestens 5, besonders bevorzugt mindestens 7, konjugierte Doppelbindungen in linearer Folge.

Bevorzugt ist die elektronenziehende Gruppe EWG ausgesucht aus Molekülfragmenten mit mindestens einer Cyano- oder Fluorsubstituenten zum Beispiel 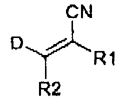 mit R1 = H, CN und R2 = H, CH₃, CN, F, (CF₂)n-CF₃ mit n=0-3 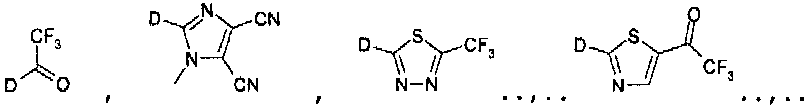 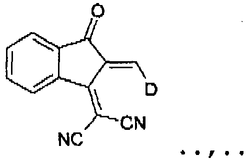 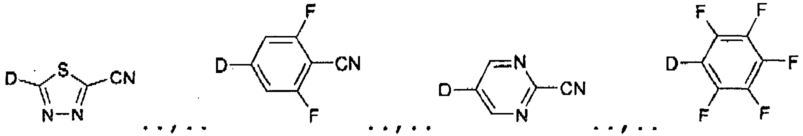 oder eine proaromatische oder chinoide Einheit, zum Beispiel 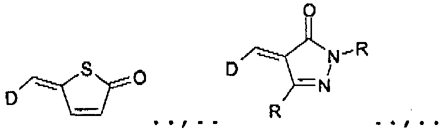 oder 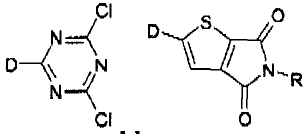 worin D die Bindungsstelle zum ausgedehnten Donorblock D darstellt und R ein Substituent ausgesucht aus verzweigtem oder geradekettigem C1-C8-Alkyl ist.

In einer weiteren Ausführungsform der Erfindung beinhaltet der ausgedehnte Donorblock eine Einheit ausgesucht aus:

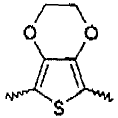

Bevorzugt liegt der Sublimationspunkt der beschriebenen Verbindung zwischen 150 - 350°C in einem Druckbereich von 10⁻⁴ bis 10⁻⁹ mbar und mindestens 50°C unter dem Zersetzungspunkt und bevorzugt mindestens 50°C unter dem Schmelzpunkt.

In einer weiteren Ausführungsform der Erfindung besteht der ausgedehnte Donorblock D aus einer Abfolge aus substituierten oder unsubstituierten heterocyclischen 5-Ringen, in dem mindestens drei benachbarte heterocyclische 5-Ringe kovalente oder nicht-kovalente Brücken aufweisen, wie beispielsweise in Formel Id dargestellt: 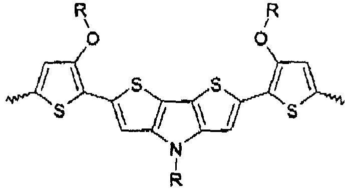 Formel Id, wobei R=Alkyl, Aryl sind.

In einer weiteren Ausführungsform der Erfindung beinhaltet der ausgedehnte Donorblock D mindestens vier annellierte heterocyclische 5-Ringe, wie beispielsweise in Formel Ie dargestellt: 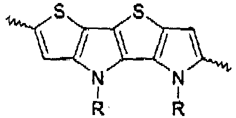 Formel Ie, wobei R=Alkyl, Aryl sind.

In einer weiteren Ausführung der Erfindung besteht der ausgedehnte Donorblock D aus einem Block von mindestens zwei annellierten heterocyclischen 5-Ringen und mindestens ein weiterer heterocyclischer 5-Ring, der über eine nicht-kovalente Brücke verbunden ist, wie beispielsweise in Formel Ic dargestellt.

Das erfindungsgemäße optoelektronische Bauelement kann eine organische Solarzelle, eine organische Leuchtdiode, ein Transistor oder eine Fotodetektor sein, besonders bevorzugt ist es eine organische Solarzelle.

Bevorzugt ist die mindestens eine organische lichtempfindliche Schicht des erfindungsgemäßen Bauelements eine lichtabsorbierende oder lichtemittierende Schicht.

Die organische lichtempfindliche Schicht in erfindungsgemäßem Bauelement ist entweder als Einzel- oder als Mischschicht vorhanden.

Unter Mischschicht wird in vorliegender Erfindung eine Schicht verstanden, welche eine der beschriebenen Verbindungen EWG-D-EWG sowie mindestens eine weitere Verbindung beinhaltet, wobei beide Verbindungen zu jeweils mindestens 16 Masse% vorhanden sind.

Das erfindungsgemäße Bauelement kann entweder ganz oder teilweise hergestellt werden durch Abscheiden der einzelnen Schichten im Vakuum mit oder ohne Trägergas, durch Auftragen aus einer oder mehrerer flüssiger Lösungen wie beispielsweise durch Aufschleudern, Auftropfen oder Drucken. Bevorzugt wird zumindest die mindestens eine organische Schicht beinhaltend eine der oben beschriebenen Verbindungen durch Auftragen im Vakuum mit oder ohne Trägergas abgeschieden. Besonders bevorzugt werden alle Schichten zwischen dem Elektrode und dem Gegenelektrode des Bauelementes durch Auftragen im Vakuum mit oder ohne Trägergas abgeschieden.

In einer weiteren Ausführungsform der Erfindung ist das Bauelement als organische pin-Solarzelle bzw. organische pin-Tandemsolarzelle oder pin-Mehrfachsolarzelle ausgeführt. Als Tandemsolarzelle wird dabei eine Solarzelle bezeichnet, die aus einem vertikalen Stapel zweier in Serie verschalteter Solarzellen besteht. Als Mehrfachsolarzelle wird dabei eine Solarzelle bezeichnet, die aus einem vertikalen Stapel mehrerer in Serie verschalteter Solarzellen besteht, wobei maximal 10 Solarzellen in einem Stapel verschaltet sind.

In einer weiteren Ausführungsform der Erfindung sind in dem Bauelement noch eine oder mehrere undotierte, teilweise dotierte oder ganz dotierte Transportschichten vorhanden. Bevorzugt haben diese Transportschichten ein Maximum der Absorption bei < 450nm, besonders bevorzugt < 400nm.

In einer weiteren Ausführungsform der Erfindung besteht das Bauelement aus einer Tandem- oder Mehrfachzelle. Bevorzugt besteht das Bauelement aus einer Kombination aus nip, ni, ip, pnip, pni, pip, nipn, nin, ipn, pnipn, pnin oder pipn-Strukturen, bei der mehrere unabhängige Kombinationen, die mindestens eine i-Schicht enthalten, übereinander gestapelt sind.

In einer weiteren Ausführungsform der Erfindung sind die Schichten des Schichtsystems des Bauelements als eine den optischen Weg des einfallenden Lichts verlängernde Lichtfalle ausgebildet.

In einer weiteren Ausführungsform der Erfindung wird das Bauelement auf ebenen, gekrümmten oder flexiblen Trägerflächen verwendet. Bevorzugt sind diese Trägerflächen Plastikfolien oder Metallfolien (z.B. Aluminium, Stahl), etc.

In einer weiteren Ausführungsform der Erfindung enthält mindestens eine der photoaktiven Mischschichten als Akzeptor ein Material aus der Gruppe der Fullerene bzw. Fullerenderivate (C₆₀, C₇₀, etc.).

In einer weiteren Ausführungsform der Erfindung bestehen die Kontakte aus Metall, einem leitfähigen Oxid, insbesondere ITO, ZnO:Al oder anderen TCOs oder einem leitfähigen Polymer, insbesondere PEDOT:PSS oder PANI.

In einer weiteren Ausführungsform ist zwischen der ersten elektronenleitenden Schicht (n-Schicht) und der auf dem Substrat befindlichen Elektrode noch eine p-dotierte Schicht vorhanden, so dass es sich um eine pnip oder pni-Struktur handelt, wobei vorzugsweise die Dotierung so hoch gewählt ist, dass der direkte pn-Kontakt keine sperrende Wirkung hat, sondern es zu verlustarmer Rekombination, bevorzugt durch einen Tunnelprozess kommt.

In einer weiteren Ausführungsform der Erfindung kann in dem Bauelement zwischen der photoaktiven i-Schicht und der auf dem Substrat befindlichen Elektrode noch eine p-dotierte Schicht vorhanden sein, so dass es sich um eine pip oder pi-Struktur handelt, wobei die zusätzliche p-dotierte Schicht eine Ferminiveaulage hat, die höchstens 0,4eV, bevorzugt aber weniger als 0,3eV unterhalb des Elektronentransportniveaus der i-Schicht liegt, so dass es zu verlustarmer Elektronenextraktion aus der i-Schicht in diese p-Schicht kommt.

In einer weiteren Ausführungsform der Erfindung ist noch ein n-Schichtsystem zwischen der p-dotierten Schicht und der Gegenelektrode vorhanden, so dass es sich um eine nipn oder ipn-Struktur handelt, wobei vorzugsweise die Dotierung so hoch gewählt ist, dass der direkte pn-Kontakt keine sperrende Wirkung hat, sondern es zu verlustarmer Rekombination, bevorzugt durch einen Tunnelprozess kommt.

In einer weiteren Ausführungsform kann in dem Bauelement noch ein n-Schichtsystem zwischen der intrinsischen, photoaktiven Schicht und der Gegenelektrode vorhanden sein, so dass es sich um eine nin- oder in-Struktur handelt, wobei die zusätzliche n-dotierte Schicht eine Ferminiveaulage hat, die höchstens 0,4eV, bevorzugt aber weniger als 0,3eV oberhalb des Löchertransportnivaus der i-Schicht liegt, so dass es zu verlustarmer Löcherextraktion aus der i-Schicht in diese n-Schicht kommt.

In einer weiteren Ausführungsform der Erfindung enthält das Bauelement ein n-Schichtsystem und/oder ein p-Schichtsystem, so dass es sich um eine pnipn, pnin, pipn- oder p-i-n-Struktur handelt, die sich in allen Fällen dadurch auszeichnen, dass - unabhängig vom Leitungstyp - die substratseitig an die photoaktive i-Schicht angrenzende Schicht eine geringere thermische Austrittsarbeit hat als die vom Substrat abgewandte an die i-Schicht grenzende Schicht, so dass photogenerierte Elektronen bevorzugt zum Substrat hin abtransportiert werden, wenn keine externe Spannung an das Bauelement angelegt wird.

In einer weiteren Ausführungsform der oben beschriebenen Strukturen sind diese als organische Tandemsolarzelle oder Mehrfachsolarzelle ausgeführt. So kann es sich bei dem Bauelement um eine Tandemzelle aus einer Kombination aus nip, ni, ip, pnip, pni, pip, nipn, nin, ipn, pnipn, pnin oder pipn-Strukturen handeln, bei der mehrere unabhängige Kombinationen, die mindestens eine i-Schicht enthalten, übereinander gestapelt sind (Kreuzkombinationen).

In einer weiteren Ausführungsform der oben beschriebenen Strukturen ist diese als eine pnipnipn-Tandemzelle ausgeführt.

In einer Ausführungsform der Erfindung ist das Bauelement mit mindestens einer anorganischen Schicht beinhaltend eine oder mehrere anorganische Materialien aufgebaut.

Überraschenderweise wurde festgestellt, dass entgegen der allgemeinen Meinung bereits ein Donorblock mit weniger als 5 heterocyclischen 5-Ringen ausreichende Absorption, gemessen am Extinktionskoeffizienten und am Absorptionsbereich, und Ladungstransporteigenschaften besitzen für eine Verwendung als organische Halbleiter, wenn dieser über geeignete Substitution verfügt. Dabei besitzen diese Verbindungen gegenüber den längerkettigen Homologen den Vorteil, dass sie meist kostengünstiger herstellbar sind, weil weniger Syntheseschritte notwendig sind und dass sie sich meist bei niedrigeren Temperaturen verdampfen lassen. Dies führt zu einer deutlichen Kostenreduktion bei der Herstellung von erfindungsgemäßen Bauelementen.

In nachfolgender Tabelle sind die wichtigsten Kennzahlen von Solarzellen als Einzelzellen mit einem Absorber basierend auf Thiophenbausteinen und Dicyanovinyl als EWG dargestellt

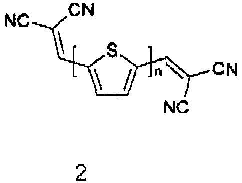

| | Füllfaktor FF (%) | Leerlaufspannung Uoc (V) | Kurzschlussstrom j (mA/cm2) |
|---|---|---|---|
| Verbindung2, n=4 (Lit.)1 | 27,6 | 1,13 | 5,9 |
| Verbindung 2, n=5 (Lit.)1 | 50,6 | 1,00 | 11,4 |
| Verbindung 1a | 51,3 | 0,92 | 9,4 |
| Verbindung 1b2 | 67,3 | 0,90 | 4,5 |
| Verbindung 1c | 50,6 | 0,88 | 6,2 |
| Verbindung 1d2 | 50,7 | 1,02 | 8,9 |

| | | | |
|---|---|---|---|
| 1) Werte aus Schueppel et al.; Phys. Rev. B 2008, 77, 085311 2) Referenzbeispiele | | | |

Die oben beschriebenen Verbindungen können nach in der Literatur bekannten Verfahren (A. Mishra, C.-Q. Ma, P. Bäuerle, Chem. Rev. 2009, 109, 1141-1278: "Functional Oligothiophenes: Molecular Design for Multi-Dimensional Nanoarchitectures and their Applications." (IF 22.76); Xiao et al. J. Am. Chem. Soc. 2005, 127(38)13281-13286; TTT: Frey et al., Chem. Commun. 2002, 2424-2425) hergestellt werden. Über ein Baukastensystem aus bekannten Reaktionen sind durch Auswahl der nötigen Reaktionen die beschriebenen Verbindungen herstellbar. Über dem Fachmann bekannte Verfahren können Substituenten in heterocyclische 5-Ringe eingeführt werden (Gronowitz, Thiophenes, Elsevier 2004), die Precursor für nicht-kovalente oder kovalente Brücken dienen. 2 heterocyclische Ringe können über bekannte Kreuzkupplungen kovalent verbunden werden.

Nachfolgend soll die Erfindung anhand einiger Ausführungsbeispiele, Referenzbeispiele und dazugehöriger Figuren eingehender erläutert werden. Es zeigen die
Fig.1 die beispielhafte Darstellung der Verbindung 1a, in
Fig.2 die Strom-Spannungs-Kurve einer Mip-Zelle mit einer 20 nm Mischschicht von Verbindung 1a mit C₆₀, in
Fig.3 die Strom-Spannungs-Kurve einer Mip-Zelle mit einer 20 nm Mischschicht von Referenz-Verbindung 1b mit C₆₀, in
Fig.4 die Strom-Spannungs-Kurve einer Mip-Zelle mit einer 20 nm Mischschicht von Verbindung 1c mit C₆₀, in
Fig.5 die Strom-Spannungs-Kurve einer Mip-Zelle mit einer 20 nm Mischschicht von Referenz-Verbindung 1d mit C₆₀, in
Fig.6 die schematische Darstellung einer Struktur eines beispielhaften photoaktiven Bauelements auf mikrostrukturiertem Substrat und in
Fig.7 die schematische Darstellung einer Struktur eines beispielhaften photoaktiven Bauelements.

In den aufgeführten Ausführungsbeispielen sind beispielhaft einige erfindungsgemäßen Bauelemente aufgezeigt. Zur Charakterisierung wichtige Kennzahlen sind der Füllfaktor, die Leerlaufspannung und Kurzschlussstrom aufgelistet, die aus der Strom-Spannungs-Kennlinie entnommen werden. Die Ausführungsbeispiele sollen die Erfindung beschreiben ohne sich auf diese zu beschränken.

### Ausführungsbeispiel 1

### Mip-Bauelement mit Verbindung 1a

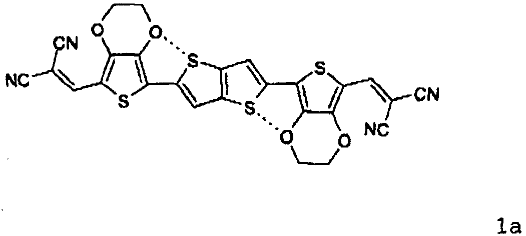

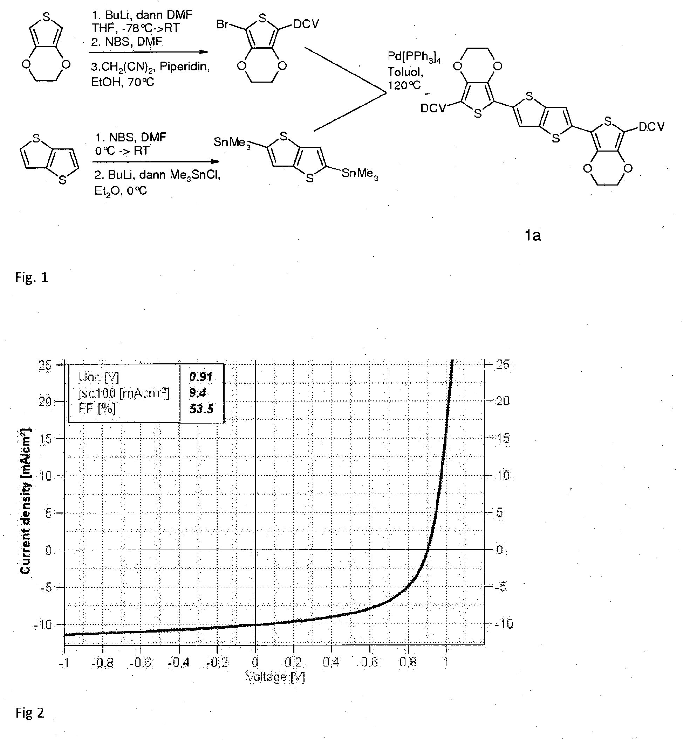

Durch Vakuumsublimation bei 10⁻⁶ bis 10⁻⁸ mbar wurde ein Mip-Bauelement bestehend aus einer Probe auf Glas mit transparentem Deckkontakt ITO, einer Schicht Buckminster Fulleren C₆₀, Mischschicht von Verbindung 1a und C₆₀ im Verhältnis 2:1, einer p-dotierter Löchertransportschicht, einer Schicht Gold hergestellt. Die Synthese der Verbindung 1a ist in Fig.1 dargestellt.

Die Mischschicht hat eine angestrebte Dicke von 20nm, ermittelt mittels Schwingquartzmonitor während des Bedampfens. Die Strom-Spannungs-Kurve einer Mip-Zelle mit einer 20 nm Mischschicht von Verbindung 1a mit C₆₀ ist in Fig.2 zu sehen.

Wichtige Kennzahlen aus dieser Kurve sind die Leerlaufspannung UOC von 0,91 V, die für einen IR-Absorber sehr hoch ist und der Füllfaktor FF von 53,5%, der in einem guten Bereich liegt für die kommerzielle Herstellung eines erfindungsgemäßen Bauelementes.

### Ausführungsbeispiel 2 (Referenz):

Mip-Bauelement mit Verbindung 1b

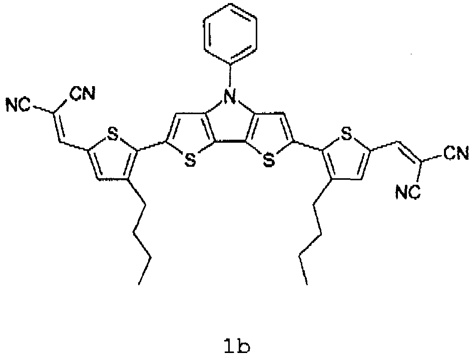

Durch Vakuumsublimation bei 10⁻⁶ bis 10⁻⁸ mbar wurde ein Mip-Bauelement bestehend aus einer Probe auf Glas mit transparentem Deckkontakt ITO, einer Schicht Buckminster Fulleren C₆₀, Mischschicht von Verbindung 1b mit C₆₀ 2:1, einer p-dotierter Löchertransportschicht, einer Schicht Gold hergestellt.

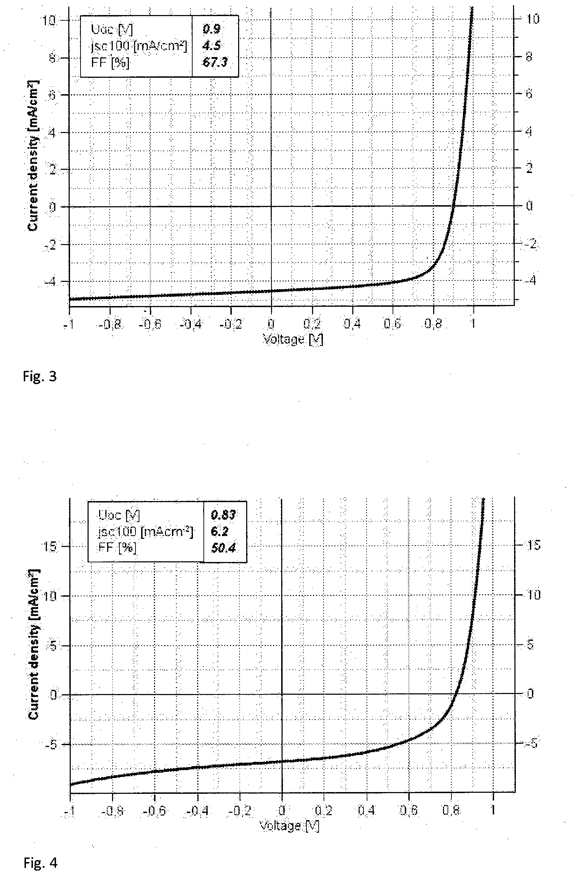

Die Mischschicht hat eine angestrebte Dicke von 10nm, ermittelt mittels Schwingquartzmonitor während des Bedampfens. Fig.3 zeigt die Strom-Spannungs-Kurve einer Mip-Zelle mit einer 10 nm Mischschicht von Verbindung 1b mit C₆₀.

Der Füllfaktor FF ist mit 67,3% sehr hoch, ebenso wie die Leerlaufspannung Uoc mit 0,9 V und der Kurzschlussstrom mit 4,5 mA, für die kommerzielle Herstellung eines erfindungsgemäßen Bauelementes.

### Ausführungsbeispiel 3:

### Mip-Bauelement mit Verbindung 1c

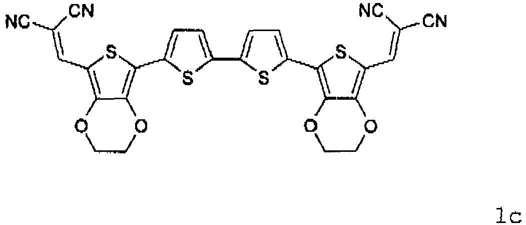

Durch Vakuumsublimation bei 10⁻⁶ bis 10⁻⁸ mbar wurde ein Mip-Bauelement bestehend aus einer Probe auf Glas mit transparentem Deckkontakt ITO, einer Schicht Buckminster Fulleren C₆₀, Mischschicht von Verbindung 1c mit C₆₀ 2:1, einer p-dotierter Löchertransportschicht, einer Schicht Gold hergestellt.

Die Mischschicht hat eine angestrebte Dicke von 20nm, ermittelt mittels Schwingquartzmonitor während des Bedampfens. Fig.4 zeigt die Strom-Spannungs-Kurve einer Mip-Zelle mit einer 20 nm Mischschicht von Verbindung 1c mit C₆₀.

Der Füllfaktor FF ist mit 50,6% in einem guten Bereich, ebenso wie die Leerlaufspannung Uoc mit 0,88 V und der Kurzschlussstrom mit 6,2 mA, für die kommerzielle Herstellung eines erfindungsgemäßen Bauelementes.

### Ausführungsbeispiel 4 (Referenz):

### Mip-Bauelement mit Verbindung 1d

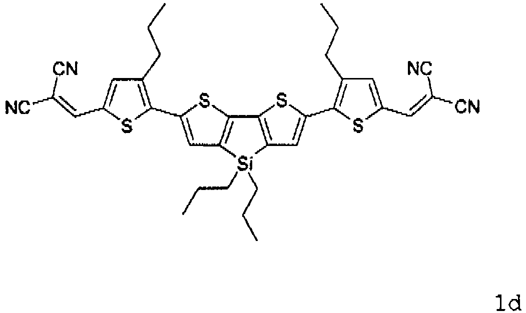

Durch Vakuumsublimation bei 10⁻⁶ bis 10⁻⁸ mbar wurde ein Mip-Bauelement bestehend aus einer Probe auf Glas mit transparentem Deckkontakt ITO, einer Schicht Buckminster Fulleren C₆₀, Mischschicht von Verbindung 1d mit C₆₀ 2:1, einer p-dotierter Löchertransportschicht, einer Schicht Gold hergestellt.

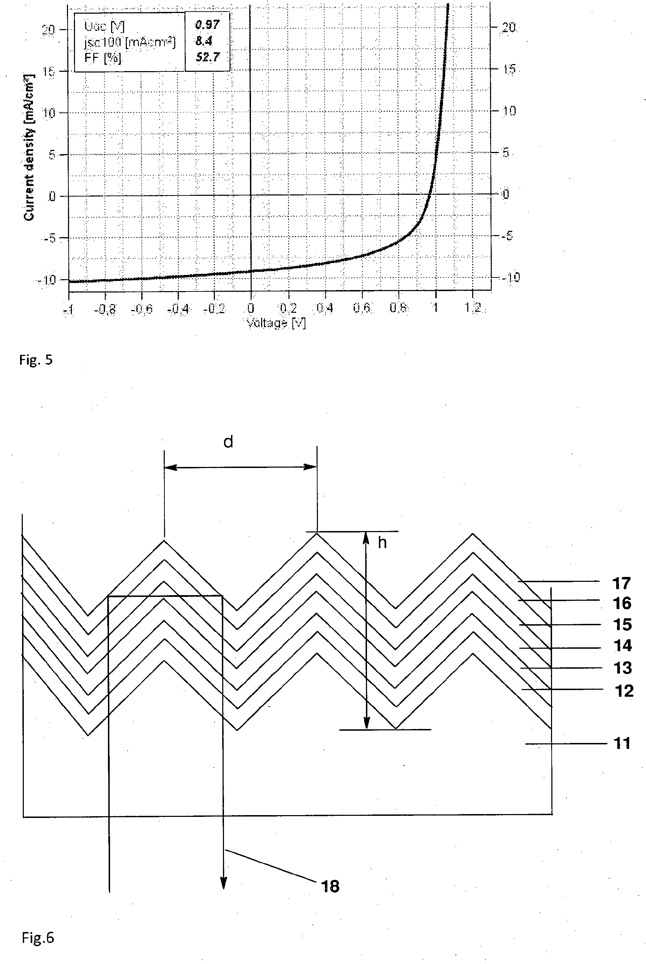

Die Mischschicht hat eine angestrebte Dicke von 20nm, ermittelt mittels Schwingquartzmonitor während des Bedampfens. Fig.5 zeigt die Strom-Spannungs-Kurve einer Mip-Zelle mit einer 20 nm Mischschicht von Verbindung 1d mit C₆₀.

Der Füllfaktor FF ist mit 50,7% in einem guten Bereich, ebenso wie die Leerlaufspannung Uoc mit 1,02V und der Kurzschlussstrom mit 8,9 mA, für die kommerzielle Herstellung eines erfindungsgemäßen Bauelementes.

In einem weiteren Ausführungsbeispiel der Erfindung wird in Fig.6 eine Lichtfalle zur Verlängerung des optischen Wegs des einfallenden Lichtes im aktiven System verwendet.

Dabei wird die Lichtfalle dadurch realisiert, dass das Bauelement auf einem periodisch mikrostrukturierten Substrat aufgebaut wird und die homogene Funktion des Bauelementes, dessen kurzschlussfreie Kontaktierung und eine homogene Verteilung des elektrischen Feldes über die gesamte Fläche durch die Verwendung einer dotierten wide-gap-Schicht gewährleistet wird. Besonders vorteilhaft ist dabei, dass das Licht die Absorberschicht, welche als Hauptkomponente die Verbindung EWG-D-EWG enthält, mindestens zweimal durchläuft, was zu einer erhöhten Lichtabsorption und dadurch zu einem verbesserten Wirkungsgrad der Solarzelle führen kann. Dies lässt sich beispielsweise wie in Fig. 6 dadurch erreichen, dass das Substrat pyramidenartige Strukturen auf der Oberfläche aufweist mit Höhen (h) und Breiten (d) jeweils im Bereich von einem bis zu mehreren hundert Mikrometern. Höhe und Breite können gleich oder unterschiedlich gewählt werden. Ebenfalls können die Pyramiden symmetrisch oder asymmetrisch aufgebaut sein. Die Breite der pyramidenartigen Strukturen liegt hierbei zwischen 1µm und 200µm. Die Höhe der pyramidenartigen Strukturen kann zwischen 1µm und 1mm liegen.
1.) Bezeichnung Fig. 6:
   1µm < d < 200µm
   1µm < h < 1mm
   11: Substrat
   12: Elektrode; z.B. ITO oder Metall (10 - 200nm)
   13: HTL oder ETL-Schichtsystem (10 - 200nm)
   14: Mischschicht 1 (10 - 200nm)
   15: Mischschicht 2 (10 - 200nm)
   16: HTL oder ETL-Schichtsystem (10 - 200nm)
   17: Elektrode; z.B. ITO oder Metall (10 - 200nm)
   18: Weg des einfallenden Lichts

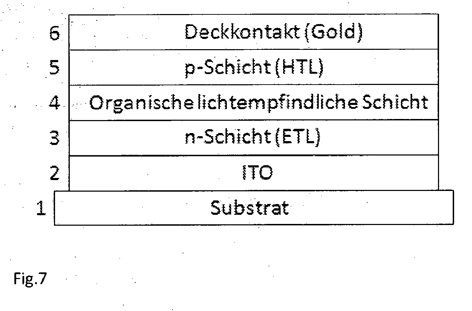

In einem weiteren Ausführungsbeispiel weist das erfindungsgemäße photoaktive Bauelement in Fig.7 folgende Schichtreihenfolge auf:
1.) Glas-Substrat **1,**
2.) ITO Grundkontakt **2,**
3.) Elektronentransportschicht (ETL) **3,**
4.) organisches lichtempfindliches Schichtsystem (10 - 200nm) **4,**
5.) Löchertransportschicht (HTL) **5,**
6.) Deckkontakt (z.B. Gold) **6.**

## Patentansprüche

1. Optoelektronisches Bauelement mit einer Elektrode (2) und einer Gegenelektrode (6) und mindestens einer organischen lichtempfindlichen Schicht (4) als Mischschicht aus zwei verschiedenen organischen Komponenten, wobei einer der Komponenten Elektronen leitend und die andere Komponente Löcher leitend ist, zwischen der Elektrode (2) und der Gegenelektrode (6), die als Hauptkomponente eine Verbindung EWG-D-EWG enthält, worin EWG gegenüber dem ausgedehnten Donorblock D elektronenziehende Eigenschaften besitzt, **wobei** der ausgedehnte Donorblock D maximal 9 konjugierte Doppelbindungen in linearer Folge besitzt, aus heterocyclischen 5-Ringen und/oder aus daraus annellierten Systemen gleicher oder gemischter Art und/oder vinylen aufgebaut ist und dass der Donorblock D mindestens einen Substituenten aufweist, **dadurch gekennzeichnet, dass** eine nicht-kovalente Brücke über gegenseitige Anziehungen zwischen räumlich nahe liegenden Atomgruppen gebildet ist.

2. Bauelement nach Anspruch 1, **dadurch gekennzeichnet, dass** die heterocyclischen 5-Ringe des ausgedehnten Donorblocks D unabhängig voneinander ausgesucht sind aus Thiophen, Selenophen, Furan oder Pyrrol und/oder aus daraus annellierten Systemen gleicher oder gemischter Art.

3. Bauelement nach einem der Ansprüche 1 oder 2, **dadurch gekennzeichnet, dass** der mindestens eine Substituent des ausgedehnten Donorblocks D n-Elektronen beispielsweise als freies Elektronenpaar oder in einer Mehrfachbindung besitzt.

4. Bauelement nach einem der Ansprüche 1 bis 3, **dadurch gekennzeichnet, dass** der mindestens eine Substituent des ausgedehnten Donorblocks D ausgesucht ist aus der Gruppe der Ethern, Thioethern, Aminen oder aus substituierten oder unsubstituierten Aromaten oder Heteroaromaten mit 4 bis 10 Atomen oder aus Alkenyl mit mindestens einer Doppelbindung in α-Position oder im Fall von 2 benachbarten Substituenten einem heterocyclischen 5-, 6- oder 7-Ring bilden.

5. Bauelement nach einem der Ansprüche 1 bis 4, **dadurch gekennzeichnet, dass** der ausgedehnte Donorblock D mindestens 5, besonders bevorzugt mindestens 7 konjugierte Doppelbindungen in linearer Folge besitzt.

6. Bauelement nach einem der Ansprüche 1 bis 5, **dadurch gekennzeichnet, dass** der ausgedehnte Donorblock mindestens zwei kovalente Verbrückungen aufweist.

7. Bauelement nach einem der Ansprüche 1 bis 6, **dadurch gekennzeichnet, dass** in dem ausgedehnten Donorblock über mindestens eine kovalente Verbrückung ein 5-Ring gebildet wird.

8. Bauelement nach einem der Ansprüche 1 bis 7, **dadurch gekennzeichnet, dass** eine kovalente Brücke über ein S, Se, O, NR, CR₂, C=CR₂ mit exocyclischer Doppelbindung, B-R, P-R und P(O)R ausgebildet ist, worin R H, ein geradkettiges oder verzweigtes Alkan oder ein substituiertes oder unsubstituiertes Aren ist, wobei über die Verbrückung ein 5-Ring gebildet wird.

9. Bauelement nach einem der Ansprüche 1 bis 8, **dadurch gekennzeichnet, dass** eine kovalente Brücke über ein - RN-NR- oder -N=N- oder -R₂C-CR₂- oder -RC=CR-ausgebildet ist, worin R unabhängig voneinander H, ein geradkettiges oder verzweigtes Alkan oder ein Aren sein kann, wobei die Verbrückung einen 6-Ring bildet.

10. Bauelement nach einem der Ansprüche 1 bis 9, **dadurch gekennzeichnet, dass** die nicht-kovalente Brücke über gegenseitige Anziehungen zwischen räumlich nahe liegenden Atomgruppen ausgewählt aus der Gruppe, die aus S-O, S-F, Se-O, Se-F, N-O, O-P besteht, gebildet ist.

11. Bauelement nach einem der Ansprüche 1 bis 10, **dadurch gekennzeichnet, dass** die gegenüber dem ausgedehnten Donorblock D elektronenziehende Gruppe EWG ausgesucht ist aus Molekülfragmenten mit mindestens einem Cyano- oder Fluorsubstituenten oder einer proaromatischen oder chinoiden Thiopheneinheit.

12. Bauelement nach einem der Ansprüche 1 bis 11, **dadurch gekennzeichnet, dass** die gegenüber dem ausgedehnten Donorblock D elektronenziehende Gruppe EWG ausgesucht ist aus 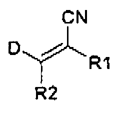 mit R1 = H, CN und R2 = H, CH³, CN, 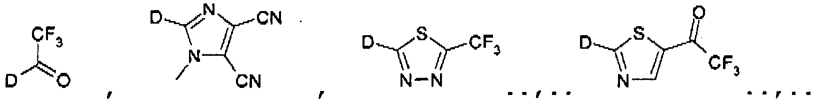 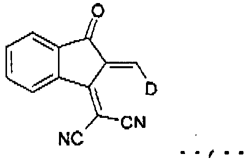 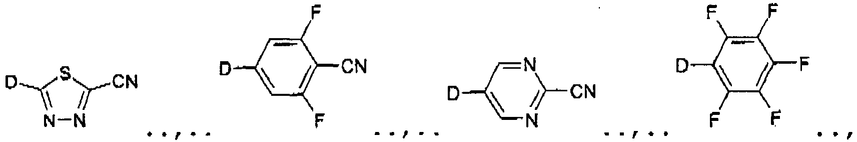 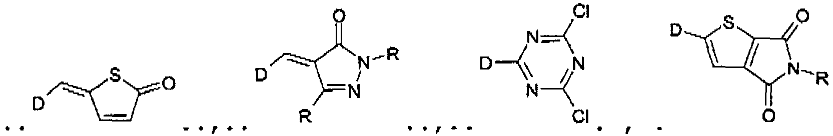 worin D die Bindungsstelle zum ausgedehnten Donorblock D darstellt und R ein Substituent ausgesucht aus verzweigtem oder geradekettigem C1-C8-Alkyl.

## Claims

1. Optoelectronic component having an electrode (2) and a counterelectrode (6) and at least one organic light-sensitive layer (4) as a mixed layer composed of two different organic components, one of the components being electron-conducting and the other component hole-conducting, between the electrode (2) and the counterelectrode (6), said layer comprising a compound EWG-D-EWG as the main component, in which EWG has electron-withdrawing properties with respect to the extensive donor block D, wherein the extensive donor block D has not more than 9 conjugated double bonds in linear succession and is formed from heterocyclic 5-membered rings and/or from vinylene and/or systems of the same type or mixed types which are fused thereto, and in that the donor block D has at least one substituent, **characterized in that** a non-covalent bridge is formed via mutual attractions between spatially proximate atom groups.

2. Component according to Claim 1, **characterized in that** the heterocyclic 5-membered rings of the extensive donor block D are each independently selected from thiophene, selenophene, furan and pyrrole and/or from systems of the same kind or mixed kinds fused thereto.

3. Component according to either of Claims 1 and 2, **characterized in that** the at least one substituent of the extensive donor block D has n electrons, for example as a free electron pair or in a multiple bond.

4. Component according to any of Claims 1 to 3, **characterized in that** the at least one substituent of the extensive donor block D is selected from the group of the ethers, thioethers, amines, or from substituted or unsubstituted aromatics or heteroaromatics having 4 to 10 atoms, or from alkenyl having at least one double bond in the a position, or, in the case of 2 adjacent substituents, form a heterocyclic 5-, 6- or 7-membered ring.

5. Component according to any of Claims 1 to 4, **characterized in that** the extensive donor block D has at least 5, more preferably at least 7, conjugated double bonds in linear succession.

6. Component according to any of Claims 1 to 5, **characterized in that** the extensive donor block has at least two covalent bridges.

7. Component according to any of Claims 1 to 6, **characterized in that** a 5-membered ring is formed in the extensive donor block via at least one covalent bridge.

8. Component according to any of Claims 1 to 7, **characterized in that** a covalent bridge is formed via an S, Se, 0, NR, CR₂, C=CR₂ with exocyclic double bond, B-R, P-R and P(O)R, in which R is H, a straight-chain or branched alkane or a substituted or unsubstituted arene, the bridge forming a 5-membered ring.

9. Component according to any of Claims 1 to 8, **characterized in that** a covalent bridge is formed via an -RN-NR- or -N=N- or -R₂C-CR₂- or -RC=CR-, in which R may independently be H, a straight-chain or branched alkane or an arene, the bridge forming a 6-membered ring.

10. Component according to any of Claims 1 to 9, **characterized in that** the non-covalent bridge is formed via mutual attractions between spatially proximate atom groups selected from the group consisting of S-O, S-F, Se-O, Se-F, N-O, O-P.

11. Component according to any of Claims 1 to 10, **characterized in that** the group EWG which is electron-withdrawing with respect to the extensive donor block D is selected from molecular fragments having at least one cyano or fluorine substituent or a proaromatic or quinoid thiophene unit.

12. Component according to any of Claims 1 to 11, **characterized in that** the group EWG which is electron-withdrawing with respect to the extensive donor block D is selected from 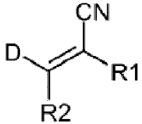 where R1 = H, CN and R2 = H, CH³, CN, 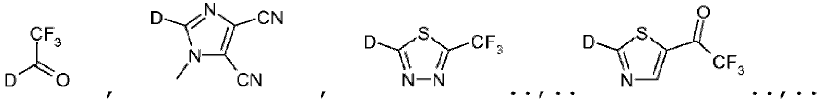 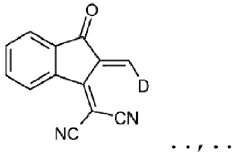 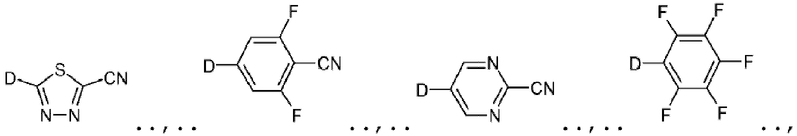 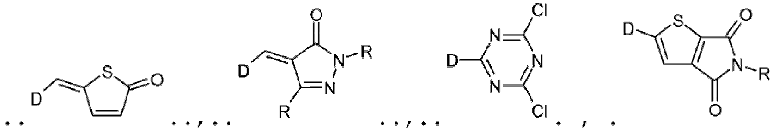 in which D represents the bonding site to the extensive donor block D and R is a substituent selected from branched or straight-chain C1-C8 alkyl.

## Revendications

1. Composant optoélectronique présentant une électrode (2) et une contre-électrode (6) et au moins une couche organique (4) sensible à la lumière en tant que couche mixte de deux constituants organiques, un des constituants guidant les électrons et l'autre constituant guidant les trous, entre l'électrode (2) et la contre-électrode (6), qui contient, comme constituant principal, un composé EWG-D-EWG, EWG présentant des propriétés d'attraction d'électrons par rapport au bloc donneur D allongé, le bloc donneur D allongé présentant au maximum 9 doubles liaisons conjuguées dans une succession linéaire, constitué de cycles hétérocycliques à 5 chaînons et/ou de systèmes annelés de ceux-ci de même type ou de type mixte et/ou de vinylène et en ce que le bloc donneur D présente au moins un substituant, **caractérisé en ce qu'**un pont non covalent est formé via des attractions opposées entre des groupes d'atomes proches dans l'espace.

2. Composant selon la revendication 1, **caractérisé en ce que** les cycles hétérocycliques à 5 chaînons du bloc donneur D allongé sont choisis, indépendamment les uns des autres, parmi le thiophène, le sélénophène, le furanne ou le pyrrole et/ou des systèmes annelés de ceux-ci de même type ou de type mixte.

3. Composant selon l'une quelconque des revendications 1 ou 2, **caractérisé en ce que** ledit au moins un substituant du bloc donneur D allongé présente des électrons π par exemple sous forme de paire d'électrons libres ou dans une liaison multiple.

4. Composant selon l'une quelconque des revendications 1 à 3, **caractérisé en ce que** ledit au moins un substituant du bloc donneur D allongé est choisi dans le groupe formé par les éthers, les thioéthers, les amines ou parmi les aromatiques ou les hétéroaromatiques substitués ou non substitués, comprenant 4 à 10 atomes de carbone ou parmi alcényle présentant au moins une double liaison en position α ou, dans le cas de 2 substituants adjacents, ceux-ci forment un cycle hétérocyclique de 5, 6 ou 7 chaînons.

5. Composant selon l'une quelconque des revendications 1 à 4, **caractérisé en ce que** le bloc donneur D allongé présente au moins 5, de manière particulièrement préférée au moins 7, doubles liaisons conjuguées dans une succession linéaire.

6. Composant selon l'une quelconque des revendications 1 à 5, **caractérisé en ce que** le bloc donneur allongé présente au moins deux pontages covalents.

7. Composant selon l'une quelconque des revendications 1 à 6, **caractérisé en ce qu'**un cycle à 5 chaînons est formé via au moins un pontage covalent dans le bloc donneur allongé.

8. Composant selon l'une quelconque des revendications 1 à 7, **caractérisé en ce qu'**un pont covalent est formé via un élément S, Se, 0, NR, CR₂, C=CR₂ avec une double liaison exocyclique, B-R, P-R et P(O)R, R représentant H, un alcane linéaire ou ramifié ou un arène substitué ou non substitué, un cycle à 5 chaînons étant formé via le pontage.

9. Composant selon l'une quelconque des revendications 1 à 8, **caractérisé en ce qu'**un pont covalent est formé via un élément -RN-NR-, -N=N- ou -R₂C-CR₂- ou -RC=CR-, R pouvant représenter, indépendamment, H, un alcane linéaire ou ramifié ou un arène, un cycle à 6 chaînons étant formé via le pontage.

10. Composant selon l'une quelconque des revendications 1 à 9, **caractérisé en ce que** le pont non covalent via des attractions opposées entre des groupes d'atomes proches dans l'espace est choisi dans le groupe constitué par S-O, S-F, Se-O, Se-F, N-O, O-P.

11. Composant selon l'une quelconque des revendications 1 à 10, **caractérisé en ce que** le groupe EWG attracteur d'électrons par rapport au groupe donneur D allongé est choisi parmi des fragments moléculaires présentant au moins un substituant cyano ou fluor ou une unité thiophène proaromatique ou quinoïde.

12. Composant selon l'une quelconque des revendications 1 à 11, **caractérisé en ce que** le groupe EWG attracteur d'électrons par rapport au groupe donneur D allongé est choisi parmi 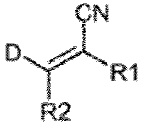 avec R1 = H, CN et R2 = H, CH₃, CN, 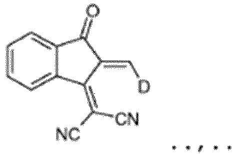 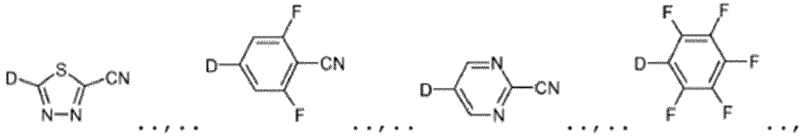 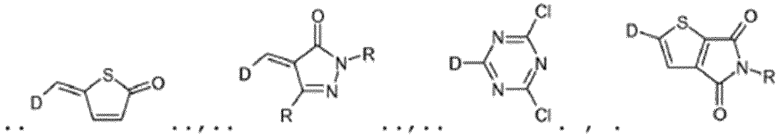 dans lesquels D représente le site de liaison au bloc donneur D allongé et R représente un substituant choisi parmi C1-C8-alkyle ramifié ou linéaire.
